# EUROPÄISCHE PATENTSCHRIFT

(11) **EP 1 032 482 B1**
(45) Veröffentlichungstag und Bekanntmachung des Hinweises auf die Patenterteilung: **08.10.2003**
(21) Anmeldenummer: 98966159.0
(22) Anmeldetag: 20.11.1998
(51) Int. Cl.: B23K 1/005

(54) **VERFAHREN UND VORRICHTUNG ZUR THERMISCHEN VERBINDUNG VON ANSCHLUSSFLÄCHEN ZWEIER SUBSTRATE**
METHOD AND DEVICE FOR THERMALLY BONDING CONNECTING SURFACES OF TWO SUBSTRATES
PROCEDE ET DISPOSITIF DESTINES A LA LIAISON THERMIQUE DE SURFACES D'ASSEMBLAGE DE DEUX SUBSTRATS

(30) Priorität: 20.11.1997 DE 19751487
(43) Veröffentlichungstag der Anmeldung: 06.09.2000
(60) Teilanmeldung: 02023748.3
(73) Patentinhaber: Pac Tech - Packaging Technologies GmbH, 14641 Nauen (DE)
(72) Erfinder: MOMENI, Kaveh, D-10965 Berlin (DE)
(74) Vertreter: Tappe, Hartmut
(86) Internationale Anmeldenummer: DE9803439
(87) Internationale Veröffentlichungsnummer: WO99026753

(56) Entgegenhaltungen:
- WO-A-91/06389
- WO-A-91/14529
- FR-A- 2 236 666
- US-A- 4 978 835

## Beschreibung

Die vorliegende Erfindung betrifft ein Verfahren zur thermischen Verbindung von in einer Überdeckungslage angeordneten Anschlußflächen zweier Substrate, wobei zumindest ein Substrat transparent ausgebildet ist und eine Beaufschlagung der Anschlußflächen mit Laserenergie von einer Rückseite des transparenten Substrats her erfolgt, wobei jede der zwischen zwei Anschlußflächen der gegenüberliegenden Substrate ausgebildeten Kontaktpaarungen separat mit Laserenergie beaufschlagt wird. Des weiteren betrifft die vorliegende Erfindung eine Vorrichtung zur Herstellung einer thermischen Verbindung von in einer Überdeckungslage angeordneten Anschlußflächen zweier Substrate gemäß dem Oberbegriff des Anspruchs 6.

Im vorliegenden Fall wird der Begriff Substrat so verstanden, daß hierunter sämtliche Bauelemente fallen, die mit einer Leiterbahnstruktur und äußeren Anschlußflächen zur Kontaktierung versehen sind; also beispielsweise Chips ebenso wie Leiterplatten. Ein bevorzugtes Anwendungsgebiet der hier vorgeschlagenen Verfahren bzw. Einsatzgebiet der hier vorgeschlagenen Vorrichtungen liegt in der Flip-Chip-Technologie sowie auch im Bereich der SMD(Surface Mounted Device)-Technologie.

Verfahren zur Verbindung bzw. Kontaktierung von in einer Überdekkungslage angeordneten Anschlußflächen zweier Substrate, bei denen Laserenergie zur Erzeugung der für die Verbindung notwendigen Wärme im Bereich der aus den Anschlußflächen gebildeten Kontaktpaarungen eingesetzt wird, sind bereits bekannt. So zeigt beispielsweise die DE 44 46 289 A1 ein Verfahren und eine Vorrichtung zur thermischen Verbindung von Anschlußflächen zweier Substrate, bei dem bzw. der zur Einleitung der Laserencrgie in die Kontaktpaarungen der Anschlußflächen eine rückwärtige Energiebeaufschlagung durch ein transparentes Substrat erfolgt. Hierbei wird zur Ausbildung des Strahlengangs zwischen einer Laseremissionseinrichtung und dem rückwärtig zu beaufschlagenden Substrat eine Lichtleitfaser verwendet, die in ihrem Querschnitt so bemessen ist, daß eine gleichzeitige Beaufschlagung sämtlicher Kontaktpaarungen mit der aus dem Endquerschnitt der Lichtleitfaser emittierten Laserstrahlung möglich ist. Um das unter dem Begriff "self-alignment" bekannte Phänomen der sich infolge der Oberflächenspannung der aufgeschmolzenen Kontaktpaarungen ergebenden Änderungen der Relativposition der zu verbindenden Substrate ausnutzen zu können, liegen bei dem bekannten Verfahren die Anschlußflächen der Substrate ohne zusätzliche Druckbelastung, in ihrer Relativposition lediglich durch das Eigengewicht des oberen Substrats gesichert, gegeneinander an.

Bei dem aus der DE 44 46 289 A1 bekannten Verfahren wird die zur Herstellung der thermischen Verbindung zwischen den Anschlußflächen benötigte Wärmeenergie im wesentlichen durch eine Abstimmung der Transparenz des Substratmatcrials und des Absorptionsvermögens des auf den Anschlußflächen angeordneten Verbindungsmaterials erreicht. Hieraus ergeben sich Einschränkungen bezüglich der freien Auswahl für das Substratmaterial und das Verbindungsmaterial.

Aus JP 4-91 493 A in: "Patent Abstracts of Japan". 1992 ist ein Verfahren bekannt, bei dem zur thermischen Verbindung von Anschlußflächen zweier Substrate eine rückwärtige Beaufschlagung eines transparenten Substrats durch eine transparente Druckplatte hindurch erfolgt, mit dem die Anschlußflächen der Substrate in Anlage gegeneinander gebracht werden. Als Druckplatte wird hierbei eine transparente Glasplatte verwendet. Die Laserenergiebeaufschlagung erfolgt bei diesem Verfahren abweichend von dem aus der DE 44 46 289 A1 bekannten Verfahren nicht für alle Kontaktpaarungen der Anschlußflächen gleichzeitig, sondern vielmehr sequentiell, wobei jeweils mehrere Kontaktpaarungen zu einer Einheit zusammengefaßt sind, die einheitlich mit Laserenergie beaufschlagt wird.

Bei dem bekannten Verfahren ermöglicht die Verwendung der transparenten Glasplatte zwar die Übertragung eines Anpressdrucks auf die miteinander Kontaktpaarungen bildenden Anschlußflächen der Substrate. Jedoch kann es aufgrund von Fertigungsungenauigkeiten, die beispielsweise zu unterschiedlichen Höhen der auf den Anschlußflächen ausgebildeten Kontaktmetallisierungen führen können, dazu kommen, daß ein Teil der einander gegenüberliegenden Anschlußflächen keinen Berührungskontakt hat und so ein nur unzureichender thermischer Energieeintrag in die betreffenden Kontaktpaarungen erfolgt, was zu Kontaktfehlern mit der möglichen Folge eines Bauteilversagens im Betrieb der miteinander kontaktierten Substrate führen kann.

Aus der US-A-4,978,835, die als nächstliegender Stand der Technik angesehen wird, ist ein Verfahren zur thermischen Verbindung von in einer Überdeckungslage angeordneten Anschlußflächen zweier Substrate bekannt, bei dem zumindest ein Substrat transparent ausgebildet und eine Beaufschlagung der Anschlußflächen mit Laserenergie von einer Rückseite des transparenten Substrats her erfolgt sowie jede der zwischen zwei Anschlußflächen der gegenüberliegenden Substrate ausgebildete Kontaktpaarung separat mit Laserenergie beaufschlagt wird.

Aus der WO-A-91/06389 ist eine Vorrichtung zur Herstellung einer thermischen Verbindung von in einer Überdeckungslage angeordneten Anschlußflächen zweier Substrate bekannt, bei der zumindest ein Substrat transparent ausgebildet ist, und eine Beaufschlagung der Anschlußflächen mit Laserenergie von einer Rückseite des transparenten Substrats her erfolgt. Die bekannte Vorrichtung weist eine Laseremissionseinrichtung zur Emission von Strahlungsenergie und eine Strahlungsübertragungseinrichtung zur Übertragung der Strahlungsenergie von der Laseremissionseinrichtung auf eine Kontaktpaarung von Anschlußflächen auf, wobei die Strahlungsübertragungseinrichtung zur Ausbildung eines zumindest zweifach umgelenkten Strahlengangs von der Laseremissionseinrichtung zur Kontaktpaarung eine erste und eine zweite Schwenkspiegeleinrichtung aufweist.

Der vorliegenden Erfindung liegt die Aufgabe zugrunde, ein Verfahren bzw. eine Vorrichtung vorzuschlagen, das bzw. die eine verbesserte Kontaktierung von Anschlußflächen zweier Substrate und damit eine erhöhte Zuverlässigkeit im Betrieb derartiger Substrate ermöglicht.

Diese Aufgabe wird durch ein Verfahren mit den Merkmalen des Anspruchs 1 gelöst.

Bei dem erfindungsgemäßen Verfahren wird jede der zwischen zwei Anschlußflächen der gegenüberliegenden Substrate ausgebildeten Kontaktpaarungen separat mit Laserenergie beaufschlagt. Hierdurch wird die Möglichkeit geschaffen, den Strahlengang, insbesondere die Fokussierung der Laserstrahlung, so einzustellen, daß eine für die jeweilige Kontaktpaarung optimale Energiebeaufschlagung erfolgt. Dabei wird in Abhängigkeit von den Winkelbewegungen einer Schwenkspiegeleinheit eine Fokussierungseinrichtung axial verfahren. Hierdurch wird es möglich, Änderungen des Strahlengangs, insbesondere Verlängerungen oder Verkürzungen des Strahlengangs, vorzunehmen, ohne daß eine Defokussierung der Laserstrahlung betreffend die jeweilig mit Laserenergie beaufschlagten Kontaktpaarung die Folge wäre.

Durch die Fokussierung der Laserstrahlung auf die jeweilige Kontaktpaarung wird auch nur ein entsprechend geringer Anteil des Substratmaterials mit Laserenergie beaufschlagt, so daß eine an sich unerwünschte Temperaturbelastung des Substratmaterials auf ein Minimum begrenzt wird. Demzufolge wirkt sich das auch bei einem transparenten Substratmaterial vorhandene Restabsorptionsvermögen weniger stark aus als bei einer ganzflächigen Beaufschlagung des Substratmaterials.

Als besonders vorteilhaft erweist es sich, wenn die von einer Laseremissionseinrichtung emittierte Strahlungsenergie in einem Strahlengang über eine erste Schwenkspiegeleinrichtung auf eine zweite Schwenkspiegeleinrichtung und von der zweiten Schwenkspiegeleinrichtung auf eine Kontaktpaarung umgelenkt wird. Durch die vorgenannte zweifache Umlenkung des Strahlengangs ist es möglich, die Laseremissionseinrichtung und die aus den beiden Substraten bestehende Substratanordnung beliebig relativ zueinander zu positionieren. Insbesondere ist es möglich, ausgehead von einer stationären Anordnung der Laseremissionseinrichtung und der Substratanordnung nacheinander folgend jede Kontaktpaarung der Anschlußflächen gezielt zu beaufschlagen, ohne die Positionierung der Laseremissionseinrichtung oder der Substratanordnung verändern zu müssen.

Wenn zur Kontrolle der Fokussierung des Strahlengangs auf die jeweilige Kontaktpaarung eine Messung der von der Kontaktpaarung emittierten Infrarot-Strahlung erfolgt, kann auf einfache Art und Weise die Pokussierung überwacht werden.

Auch ist es möglich, zur Kontrolle der Fokussierung des Strahlengangs auf die jeweilige Kontaktpaarung eine optische Überwachung der Kontaktpaarung mittels einer Kameraeinrichtung durchzuführen, wozu eine Auskopplung des sichtbaren Lichts aus dem Strahlengang erfolgt. Durch Verwendung ein und desselben Strahlengangs sowohl zur Energiebeaufschlagung der Kontaktpaarung als auch zur Überwachung der korrekten Fokussierung der Laserstrahlung auf die Kontaktpaarung wird die Überwachung mit minimalem zusätzlichen apparativen Aufwand möglich. Darüber hinaus sind wegen der vorgenannten Doppelnutzung des Strahlengangs auch keine optischen Übertragungsfehler möglich, die Abweichungen zwischen der tatsächlichen Fokussierung und der ermittelten Fokussierung möglich machen würden.

Zur Kontrolle der Fokussierung der Laserstrahlung auf die Kontaktpaarung hat sich auch ein Verfahren als vorteilhaft erwiesen, bei dem dem Strahlengang der Laseremissionseinrichtung, die als eine vorzugsweise im Impulsbetrieb betriebene Leistungslasereinrichtung ausgeführt ist, der Strahlengang eines relativ schwachen Pilotlasers, der permanent emittiert, überlagert wird, um eine Kontrolle der Fokussierung des Strahlengangs des Leistungslasers mittels eincr Kontrolle der Fokussierung des Strahlengangs des Pilotlasers zu ermöglichen. Der Vorteil dieses Verfahrens liegt darin, daß aufgrund der übereinstimmenden Wellenlängen von Pilotlaser und Leistungslaser keine Fokussierungsfehler infolgc von Phasenverschiebungen der emittierten Laserstrahlung auftreten können. Als Pilotlaser kann dabei eine in bzw. an der Laseremissionseinrichtung installierte Laserdiode verwendet werden. Als Kamera wird besonders vorteilhaft eine Infrarot-Kamera eingesetzt.

Eine weitere, besonders vorteilhafte Variante des Verfahrens besteht darin, zur Kontrolle der in der Kontaktpaarung effektiven Laserleistung eine Überwachung der Kontaktpaarung mittels der Kameraeinrichtung und eine Messung der von dieser Kontaktpaarung emittierten Infrarot-Strahlung durchzuführen. Diese Art der Kontrolle erweist sich als besonders genau, da ein sich auf das Ergebnis der Leistungskontrolle durch Messung der Infrarot-Emission entscheidend auswirkender Parameter, nämlich die Fokussierung der Kontaktpaarung, berücksichtigt wird. Hierdurch kann beispielsweise verhindert wurden, daß eine lediglich durch eine Defokussierung verursachte unzureichende Laserleistung durch eine Erhöhung der Laserenergie ausgeglichen wird, obwohl an sich eine Korrektur der Fokussierung ohne Erhöhung der Laserenergie ausreichend wäre, um den notwendigen Binergieeintrag in die Kontaktpaarung zu erzielen.

Bine zur Lösung der der Erfindung zugrunde liegenden Aufgabe geeignete Vorrichtung weist die Merkmale des Anspruchs 6 auf.

Die erfindungsgemäße Vorrichtung weist eine Strahlungsübertragungseinrichtung zur Ausbildung eines zumindest zweifach umgelenkten Strahlengangs von der Laseremissionseinrichtung zur Kontaktpaarung mit einer ersten und einer zweiten Schwenkspiegeleinrichtung auf, wobei im Strahlengang zwischen der Laseremissionseinrichtung und der Kontaktpaarung eine axial im Strahlengang verfahrbare Fokussierungseinrichtung angeordnet ist.

Dieser besondere Aufbau der Strahlungsübertragungseinrichtung ermöglicht eine stationäre Positionierung der Laseremissionseinrichtung und der aus den miteinander zu kontaktierenden Substraten gebildeten Substratanordnung, die während der aufeinanderfolgenden Kontaktierung sämtlicher Kontaktpaarungen der Anschlußflächen der einander gegenüberliegend angeordneten Substrate aufrecht erhalten werden kenn. Darüber hinaus ermöglicht der vorgenannte, erfindungsgemäße Aufbau der Strahlungsübertragungseinrichtung eine separate Energiebeaufschlagung sämtlicher Kontaktpaarungen, so daß bei jeder Kontaktpaarung der jeweils optimale Strahlengang zur Erzielung eines entsprechend optimalen Kontaktierungsergebnisses einstellbar ist. Um eine durch Drehung der Schwenkspiegeleinrichtung verursachte Änderung des Strahlengangs, insbesondere eine Verlängerung oder Verkürzung des Strahlengangs, welche eine Defokussierung des Laserstrahls an den Kontaktpaarungen bewirken kann, auszugleichen, ist die axial verschiebbare Fokussiereinrichtung, die beispielsweise eine Sammellinse aufweist, im Strahlengang vorgesehen.

Wenn die Fokussierungseinrichtung im Strahlengang zwischen der ersten Schwenkspiegeleinrichtung und der Laseremissionseinrichtung angeordnet ist, lassen sich sowohl von der ersten Schwenkspiegeleinrichtung als auch von der zweiten Schwenkspiegeleinrichtung verursachte Defokussierungen durch die Fokussierungseinrichtung kompensieren.

Als besonders vorteilhaft erweist es sich, wenn zwischen der Laseremissionseinrichtung und der Fokussierungseinrichtung eine Strahlungsauskopplungseinrichtung im Strahlengang angeordnet ist zur Auskopplung und Umlenkung des sichtbaren Lichts aus dem Strahlengang in eine Kameraeinrichtung. Hierdurch ist eine unmittelbare optische Überwachung der Fokussierung der Laserstrahlung auf die jeweilige Kontaktpaarung möglich.

Nachfolgend wird eine Ausführungsform einer erfindungsgemäßen Vorrichtung, die zur Durchführung einer Variante des erfindungsgemäßen Verfahrens geeignet ist, unter Bezugnahme auf die Zeichnungen näher erläutert. Es zeigen:
- **Fig. 1**: eine Ausführungsform einer Vorrichtung zur thermischen Kontaktierung zweier in einer Andruckeinrichtung angeordneter Substrate;
- **Fig. 2**: eine weitere Ausführungsform einer Vorrichtung zur thermischen Kontaktierung zweier in einer Andruckeinrichtung angeordneter Substrate;
- **Fig 3**: eine weitere Ausführungsform der in den **Fig. 1** und **2** dargestellten Andruckeinrichtung;
- **Fig 4**: einen besondere Anwendung des Verfahrens.

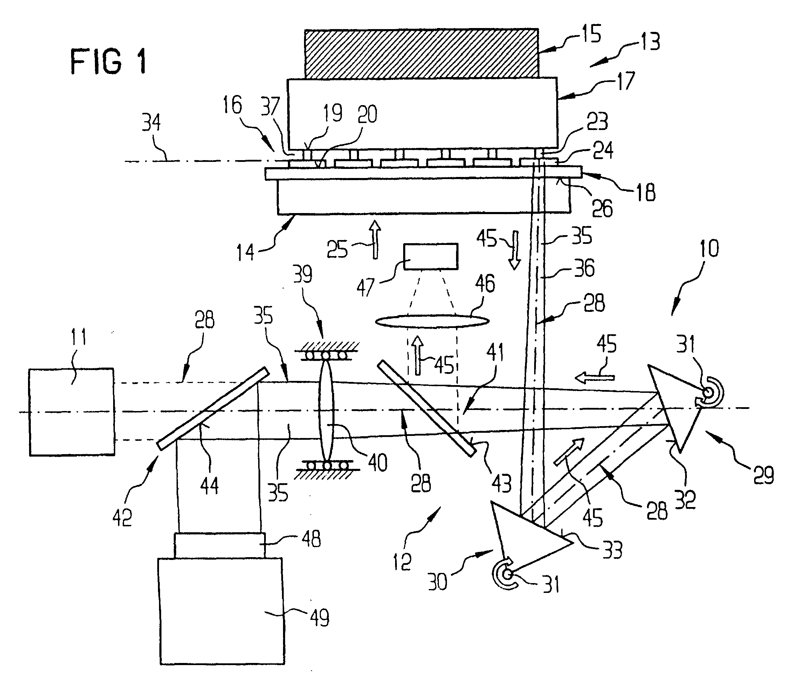

**Fig. 1** zeigt eine Laserverbindungsvorrichtung 10 mit einer Laseremissionseinrichtung 11, einer Strahlungsübertragungseinrichtung 12 und einer Substrataufnahmeeinrichtung 13. Die Substrataufnahmeeinrichtung 13 umfaßt im vorliegenden Fall eine Andruckeinrichtung 14 und eine Gegenhalteeinrichtung 15.

Die Substrataufnahmeeinrichtung 13 dient zur Aufnahme einer Substratanordnung 16 aus zwei Substraten 17, 18, die mit einer hier nicht näher dargestellten Leiterbahnstruktur versehen sind und äußere Anschlüsse 19 bzw. 20 zur Kontaktierung aufweisen. Im vorliegenden Fall handelt es sich bei dem Substrat 17 um einen mit einer peripheren Anschlußflächenanordnung versehenen Chip, dessen Anschlüsse 19 mit den Anschlüssen 20 des ebenfalls eine periphere Anschlußflächenanordnung aufweisenden Substrats 18 kontaktiert werden sollen. Bei dem Substrat 18 handelt es sich im vorliegenden Fall um eine Trägerplatine, deren Anschlüssc 20 mit den Anschlüssen 19 verbunden werden sollen. Hierzu sind die Anschlüsse 19 und 20 mit erhöhten Kontaktmetallisierungen 23 bzw. 24 versehen, die das für eine thermische Verbindung benötigte Verbindungsmaterial bereitstellen.

Um für die nachfolgende thermisch bewirkte, stoffschlüssige Verbindung zwischen den Anschlußflächen 19 des Substrats 17 und den Anschlußflächen 20 des Substrats 18 einen möglichst spaltfreien Berührungskontakt herzustellen, ist die Andruckeinrichtung 14 in Richtung des Pfeils 25 gegen eine Rückseite 26 des unteren Substrats 18 bewegbar, wobei der notwendige Gegendruck durch die Gegenhalteeinrichtung 15 aufgebracht wird.

Die Gegenhaltecinrichtung 15 kann gleichzeitig als Handhabungseinrichtung ausgebildet sein, die dazu dient, das Substrat 17 aus einer hier nicht näher dargestellten Bereitstellungsposition in die in **Fig. 1** dargestellte Kontaktierungsposition zu überführen. Die hierzu notwendige Haftung zwischen dem Substrat 17 und der als Handhabungseinrichtung ausgeführten Gegenhalteeinrichtung 15 kann beispielsweise über einen zwischen der Gegenhaltecinrichtung 15 und dem Substrat 17 anliegenden Unterdruck erzeugt werden.

Die Andruckeinrichtung 14 sowie das auf der Andruckeinrichtung 14 angeordnete Substrat 18 weisen eine für die Wellenlänge einer aus der Lasercmissionseinrichtung 11 emittierten Laserstrahlung 27 transparente Zusammensetzung auf.

Zwischen der Laseremissionseinrichtung 11 und der Substratanordnung 16 in der Substrataufnahmeeinrichtung 13 ist die Strahlungsübertragungseinrichtung 12 mit zwei Schwcnkspiegeleinrichtungen 29 und 30 angeordnet. Wie aus **Fig. 1** deutlich wird, weisen die Schwenkspiegeleinrichtungen 29, 30 jeweils eine um eine quer zu einem Strahlengang 28 verlaufende Schwenkachse 31 und eine parallel zum Strahlengang verlaufende Schwenkachse 38 um zwei Raumachsen verschwenkbare Spiegelfläche 32 bzw 33 auf. Durch die mittels der zwei Schwenkspiegeleinrichtungen 29, 30 bewirkte doppelte Umlenkung des Strahlengangs 28 wird ausgehend von einem im wesentlichen parallel zu einer Verbindungsebene 34 der Substratanordnung 16 verlaufenden Strahlengangabschnitt 35 ein im wesentlichen quer zur Verbindungsebene 34 verlaufender Strahlengangabschnitt 36 möglich. Dabei ermöglicht eine Schwenkbewegung der im Strahlengang 28 der ersten Schwenkspiegeleinrichtung 29 nachfolgend angeordneten zweiten Schwenkspiegeleinrichtung 30 bei entsprechender Winkelnachführung der ersten Schwenkspiegeleinrichtung 29 eine einander nachfolgende separate Beaufschlagung sämtlicher der aus jeweils zwei Anschlüssen 19 und 20 gebildeten Kontaktpaarungen 37 mit Laserenergie. Dabei können sowohl die Laseremissionseinrichtung 11 bzw. die in der Substrataufnahmecinrichtung 13 angeordnete Substratanordnung 16 ihre Position unverändert beibehalten.

Aufgrund der transparenten Ausbildung der Andruckeinrichtung 14 sowie des Substrats 18 erfolgt die Beaufschlagung jeder Kontaktpaarung 37 durch die Andruckeinrichtung 14 und das Substrat 18 hindurch. Wegen des Strahlungsabsorptionsverhaltens der Anschlußflächcn 20 kommt es zu einer Erwärmung und cinem zumindest teilweisen Aufschmelzen der Kontaktmetallisierungen 23, 24 mit einer nachfolgenden stoffschlüssigen Verbindung zwischen den Anschlüssen 19 und 20.

Aus der in **Fig. 1** gewählten Darstellung, die als Beispiel für die einander nachfolgende Beaufschlagung sämtlicher Kontaktpaarungen 37 eine Laserenergiebeaufschlagung einer am rechten Rand der Substratanordnung 16 angeordneten Kontaktpaarung 37 zeigt, wird deutlich, daß eine bezogen auf den Abstand zwischen der Spiegelfläche 33 und der Kontaktpaarung 37 eingestellte Brennweite, die eine exakte Fokussierung der Laserstrahlung 27 auf die Kontaktpaarung 37 ermöglicht, beispielsweise bei einer Energiebeaufschlagung einer am linken Rand der Substratanordnung 16 angeordneten Kontaktpaarung 37 wegen des verlängerten Strahlengangabschnitts 36 angepaßt werden muß. Hierzu ist im Strahlengangabschnitt 35 eine axial im Strahlengang verfahrbare Fokussierungseinrichtung 39 mit einer Sammellinse 40 vorgesehen.

Bei dem in **Fig. 1** dargestellten Ausführungsbeispiel der Laserverbindungsvorrichtung 10 sind in den Strahlengang 28 zwei Strahlungsauskopplungseinrichtungen 41 und 42 eingesetzt, die jeweils in Emissionsrichtung der Laseremissionseinrichtung 11 für die Laserstrahlung 27 durchlässig sind, jedoch von der jeweiligen Kontaktpaarung 37 emittierte bzw. reflektierte Strahlungsanteile entsprechend dem jeweils gewählten Anstellwinkel einer jeweiligen Spiegelfläche 43 bzw. 44 reflektieren. Die Strahlungsauskopplungseinrichtung 41 reflektiert, wie in **Fig. 1** dargestellt, über die Spiegelfläche 43 einen von der Kontaktpaarung 37 infolge deren Erwärmung emittierten Infrarot-Strahlungsanteil 45 nach vorheriger Bündelung durch eine Sammellinse 46 in einen Infrarot-Detektor 47. Die Strahlungsauskopplungseinrichtung 42 reflektiert den von der Kontaktpaarung 37 durch das transparente Substrat 18 und die transparente Andruckeinrichtung 14 reflektierten Anteil des im Strahlengang 28 vorhandenen sichtbaren Lichts über die Spiegelfläche 44 in eine Objektivlinse 48 einer Kameraeinrichtung 49 und ermöglicht somit mittels der Kameraeinrichtung 49 eine Überwachung der Kontaktpaarung 37.

In der in **Fig. 1** dargestellten Kombination mit der Fokussierungseinrichtung 39 eignet sich die Kameraeinrichtung 49 insbesondere im Zusammenwirken mit einer Bildverarbeitungseinrichtung zur Definition einer auf die Fokussierungscinrichtung 39 wirkenden Stellgröße nicht nur zu einer Überwachung der exakten Fokussierung der Laserstrahlung 27 auf die jeweilige Kontaktpaarung 37. sondern vielmehr auch zur Verstellung der Fokussierungseinrichtung. Basierend auf einer exakten Fokussierung der Laserstrahlung 27 auf die Kontaktpaarung 37 kann dann mittels des Infrarot-Detektors 47 eine Kontrolle der in der Kontaktpaarung 37 effektiven Laserleistung durchgeführt werden.

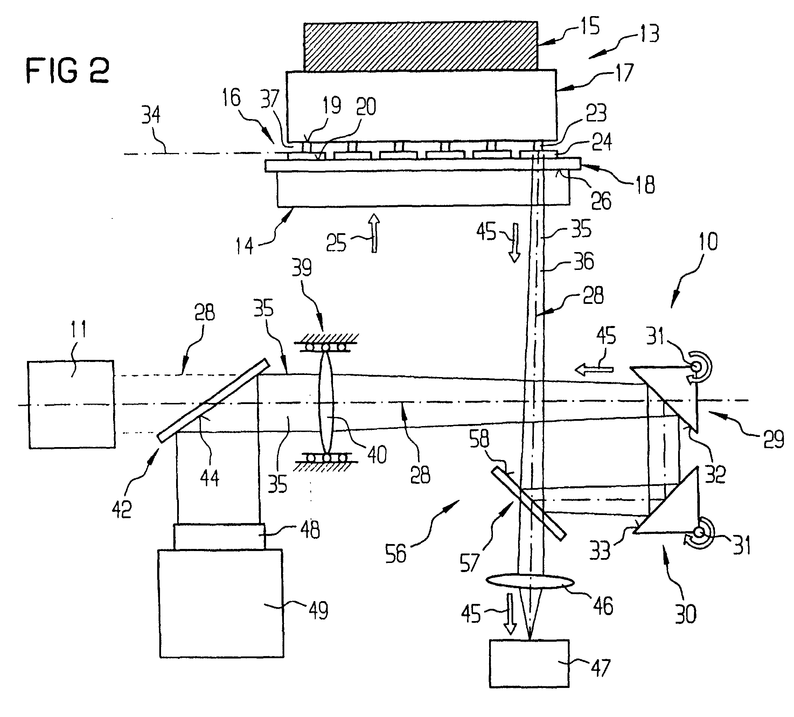

**Fig. 2** zeigt die Laserverbindungsvorrichtung 10 mit einer Strahlungsübertragungseinrichtung 56, die gegenüber der Strahlungsübertragungseinrichtung 12 **in Fig. 1** einen abweichenden Aufbau mit geänderter Anordnung des Infrarot-Detektors 47 aufweist. Ansonsten werden in der in **Fig. 2** dargestellten Laserverbindungsvorrichtung 10 entsprechend den identisch verwendeten Bezugszeichen auch identisch verwendete Komponenten eingesetzt. Wie aus einem Vergleich der **Fig. 1** und **2** deutlich wird, befinden sich die Schwenkspiegeleinrichtungen 29 und 30 in geänderter Relativanordnung, derart, daß die Schwenkspiegeleinrichtung 29 ihre Position beibehalten hat und die Schwenkspiegeleinrichtung 30 nunmehr unterhalb der Schwenkspiegeleinrichtung 29 angeordnet ist. Ferner ist anstatt der Strahlungsauskopplungseinrichtung 41 eine Strahlungsauskopplungseinrichtung 57 mit einer für Infrarot-Strahlung transparenten und für die Laserstrahlung 27 der Laseremissionseinrichtung 11 hoch reflektierenden Spiegelfläche 58 vorgesehen. Hierdurch wird es möglich, wie aus **Fig. 2** ersichtlich, den Infrarot-Detektor 47 ohne Strahlengangumlenkung direkt auf der optischen Achse der vom Anschluß 20 reflektierten Infrarot-Strahlung anzuordnen. Insgesamt wird durch die in **Fig. 2** dargestellte Anordnung eine genauere Erfassung des Infrarot-Strahlungsanteils 45 möglich.

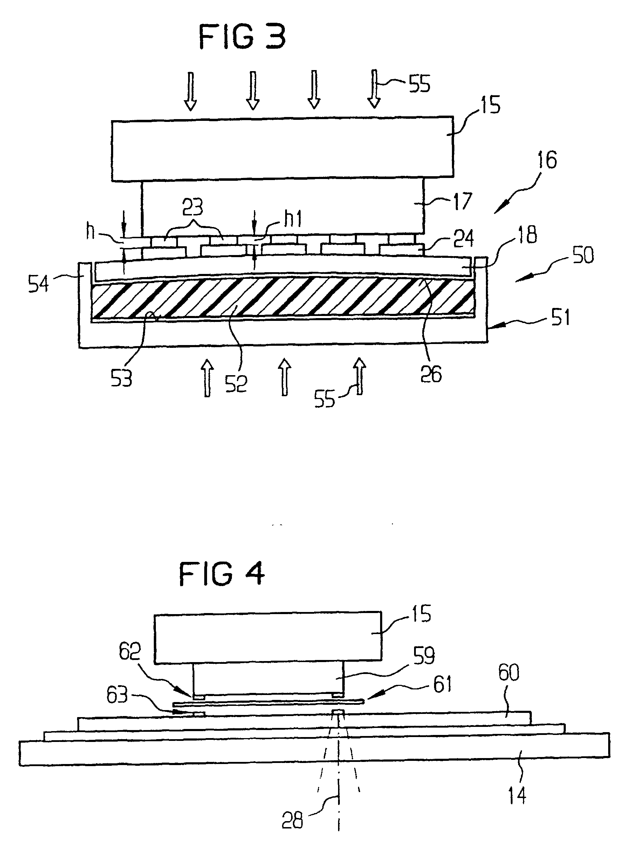

**Fig. 3** zeigt eine gegenüber der in den **Fig. 1** und **2** dargestellten Andrukkeinrichtung 14 variierte Andruckeinrichtung 50 mit einer transparenten und starr ausgebildeten Krafteinleitungseinrichtung 51, die beispielsweise aus Glas oder einem transparenten Epoxydharz gebildet sein kann. Zwischen der Krafteinleitungseinrichtung 51 und der Rückseite 26 des Substrats 18 befindet sich ein transparentes, inkompressibles und darüber hinaus verformbares Volumen, das im vorliegenden Fall als Silikonkissen 52 ausgebildet ist. Das Silikonkissen 52 wird im vorliegenden Fall von einer Aufnahme 53 der Krafteinlcitungseinrichtung 51 aufgenommen, wobei die Aufnahme 53 durch einen umlaufenden Randsteg 54 der Krafteinleitungseinrichtung 51 gebildet ist.

Bei einer durch die Kraftpfeile 55 angedeuteten Druckbeaufschlagung der Substratanordnung 16 durch die Krafteinleitungseinrichtung 51 zeigt das durch das Silikonkissen 52 gebildete, inkompressible und verformbare Volumen ein flüssigkeitsanaloges Druckverhalten, so daß beispielsweise Abweichungen in den Höhen h und h₁ der Kontaktmetallisierungen 23 des Substrats 17 durch eine entsprechende Verformung des Substrats 18 kompensiert werden. Dabei dient der Randsteg 54 als quer zur Druckrichtung wirkende Verformungsbegrenzung.

Wie **Fig. 3** zeigt, wird durch die Verwendung des Druckkissens 52 eine Ausbildung von Spalten zwischen den Kontaktmetallisierungen 23 und 24 der einander gegenüberliegend angeordneten Substrate 17 und 18 trotz Abweichungen in den Höhen h und h₁ der Kontaktmetallisierungen 23 verhindert. Aus dem Vorstehenden wird deutlich, daß die Anordnung eines transparenten, inkompressiblen und verformbaren Volumens in einer Andruckeinrichtung bei Durchführung einer Kontaktierung von einander gegenüberliegenden Anschlüssen zweier Substrate auch unabhängig von der Art der Beaufschlagung der Anschlußflächen mit Laserenergie, also sowohl bei separater als auch bei gemeinschaftlicher Beaufschlagung der Anschlußflächen mit Laserenergie, wirksam die Qualität der Kontaktierung verbessert, da in jedem Fall einer Spaltausbildung zwischen den Anschlüssen entgegengewirkt wird.

Die anhand der vorstchenden Ausführungsbeispiele beschriebenen Verfahrensvarianten sowie die dabei eingesetzten Vorrichtungen lassen sich unter anderem vorteilhaft bei der Herstellung von Chipkartcn sowie der Herstellung von gehäusten, insbesondere nach der "Chip Scale Packaging"-Technologie hergestellten Chipmodulen verwenden. Unabhängig von der jeweiligen Verfahrensvariante oder dem jeweiligen Ausführungsbeispiel der Vorrichtung lassen sich auch Verbindungen eines insbesondere als Chip 59 ausgebildeten Substrats mit einem Trägcrsubstrat 60 herstellen, wie in **Fig. 4** dargestellt.

Im Unterschied zu den in den **Fig. 1** bis **3** dargestellten Verbindungen wird bei der thermischen Verbindung zwischen dem Chip 59 und dem Trägersubstrat 60 unter Einsatz der in den **Fig 1, 2** oder **3** dargestellten Vorrichtungen zwischen dem Chip 59 und dem Trägersubstrat 60 ein Klebstofffilm 61 angeordnet, der die Stabilität des Verbundes von Chip 59 und Trägersubstrat 60 erhöht. Der in **Fig 4** dargestellte Klebstofffilm 61 kann bereits vor Herstellung der Verbindung auf einem der beiden Substrate 59 oder 60, oder wie dargestellt als separate Komponente zwischen den Substraten 59, 60 angeordnet werden. Je nachdem ob es sich bei dem Klebstofffilm 61 um ein elektrisch nicht leitendes oder leitendes Material handelt, kann vor Herstellung der thermischen Verbindung mittels der Laserverbindungseinrichtung durch die Andruckeinrichtung 14 und die Gegenhalteeinrichtung 15 ein unmittelbarer Kontakt zwischen Anschlüssen 62 des Chips 59 und Anschlüssen 63 des Trägersubstrats 60 unter Verdrängung des zwischenlicgend angeordneten Klebstofffilms 61 oder ein über den Klebstoffflilm 61 ermöglichter mittelbarer Kontakt zwischen den Anschlüssen 62 des Chips 59 und den Anschlüssen 63 des Trägcrsubstrats 60 hergestellt werden.

Je nach Ausführung der elektrisch leitenden Verbindung zwischen den Anschlüssen 62, 63 kann die Laserverbindungseinrichtung zum Löten, zur Herstellung einer Klebstofffixierung vor Aushärtung einer Klebeverbindung oder unterstützt durch die Andruckeinrichtung auch zur Herstellung einer Thermokompressions-Verbindung eingesetzt werden. Neben der Herstellung der thermischen Verbindung zwischen den jeweiligen Kontaktpartnern kann die Laserverbindungseinrichtung zur Aushärtung des Klebstoffs verwendet werden.

## Patentansprüche

1. Verfahren zur thermischen Verbindung von in einer Überdeckungslage angeordneten Anschlussflächen zweier Substrate, wobei zumindest ein Substrat transparent ausgebildet ist, und eine Beaufschlagung der Anschlussflächen mit Laserenergie von einer Rückseite des transparenten Substrats her erfolgt, wobei jede der zwischen zwei Anschlussflächen der gegenüberliegenden Substrate ausgebildeten Kontaktpaarungen separat mit Laserenergie beaufschlagt wird,
**dadurch gekennzeichnet,**
**dass** in einem Strahlengang (28) zwischen einer Laseremissionseinrichtung (11) und der Kontaktpaarung (37) eine Fokussierungseinrichtung (39) in Abhängigkeit von Winkelbewegungen einer Schwenkspiegeleinrichtung (29, 30) axial verfahren wird.

2. Verfahren nach Anspruch 1,
**dadurch gekennzeichnet,**
**dass** die von der Laseremissionseinrichtung (11) emittierte Laserstrahlung (27) im Strahlengang (28) über eine erste Schwenkspiegeleinrichtung (29) auf eine zweite Schwenkspiegeleinrichtung (30) und von der zweiten Schwenkspiegeleinrichtung (30) auf eine Kontaktpaarung (37) umgelenkt wird.

3. Verfahren nach Anspruch 1 oder 2,
**dadurch gekennzeichnet,**
**dass** zur Kontrolle der Fokussierung der Laserstrahlung (27) auf die jeweilige Kontaktpaarung (37) eine Messung der von der Kontaktpaarung emittierten Infrarot-Strahlung (45) erfolgt

4. Verfahren nach Anspruch 1 oder 2,
**dadurch gekennzeichnet,**
**dass** zur Kontrolle der Fokussierung der Laserstrahlung (27) auf die jeweilige Kontaktpaarung (37) eine optische Überwachung der Kontaktpaarung mittels einer Kameraeinrichtung (49) erfolgt, wozu eine Auskopplung des sichtbaren Lichts aus dem Strahlengang (28) der Laserstrahlung (27) erfolgt.

5. Verfahren nach Anspruch 1 oder 2,
**dadurch gekennzeichnet,**
**dass** zur Kontrolle der in der Kontaktpaarung (37) effektiven Laserleistung eine Überwachung der Kontaktpaarung (37) mittels der Kameraeinrichtung (49) und eine Messung der von dieser Kontaktpaarung emittierten Infrarot-Strahlung (45) erfolgt.

6. Vorrichtung zur Herstellung einer thermischen Verbindung von in einer Überdeckungslage angeordneten Anschlussflächen zweier Substrate, wobei zumindest ein Substrat transparent ausgebildet ist, und eine Beaufschlagung der Anschlussflächen mit Laserenergie von einer Rückseite des transparenten Substrats her erfolgt, aufweisend
eine Laseremissionseinrichtung zur Emission von Strahlungsenergie und
eine Strahlungsübertragungseinrichtung zur Übertragung der Strahlungsenergie von der Laseremissionseinrichtung auf eine Kontaktpaarung von Anschlussflächen,
wobei die Strahlungsübertragungseinrichtung zur Ausbildung eines zumindest zweifach umgelenkten Strahlengangs von der Laseremissionseinrichtung zur Kontaktpaarung eine erste und eine zweite Schwenkspiegeleinrichtung aufweist,
**dadurch gekennzeichnet,**
**dass** im Strahlengang (28) zwischen der Laseremissionseinrichtung (11) und der Kontaktpaarung (37) eine axial im Strahlengang verfahrbare Fokussierungseinrichtung (39) angeordnet ist.

7. Vorrichtung nach Anspruch 6,
**dadurch gekennzeichnet,**
**dass** die Fokussierungseinrichtung (39) im Strahlengang (28) zwischen der ersten Schwenkspiegeleinrichtung (29) und der Laseremissionseinrichtung (11) angeordnet ist.

8. Vorrichtung nach Anspruch 7,
**dadurch gekennzeichnet,**
**dass** zwischen der Laseremissionseinrichtung (11) und der Fokussierungseinrichtung (39) eine Strahlungsauskopplungseinrichtung (42) im Strahlengang (28) angeordnet ist zur Auskopplung und Umlenkung des sichtbaren Lichts aus dem Strahlengang in eine Kameraeinrichtung (49).

## Claims

1. A method for the thermal connection of overlapping connecting surfaces of two substrates, at least one substrate being transparent and laser energy being applied to the connecting surfaces from a rear side of the transparent substrate, laser energy being applied separately to each of the contact pairs constructed between two connecting surfaces of the opposing substrates, **characterised in that** a focusing device (39) is axially displaced in a beam path (28) between a laser emitting device (11) and the contact pair (37) as a function of angular movements of a swivel mirror device (29, 30).

2. A method according to claim 1, **characterised in that** the laser beam (27) emitted by the laser emitting device (11) is deflected in the beam path (28) via a first swivel mirror device (29) onto a second swivel mirror device (30) and by the second swivel mirror device (30) onto a contact pair (37).

3. A method according to claim 1 or 2, **characterised in that** a measurement of the infrared radiation (45) emitted by the contact pair is effected in order to control the focusing of the laser beam (27) onto the respective contact pair (37).

4. A method according to claim 1 or 2, **characterised in that** an optical monitoring of the contact pair is effected by means of a camera device (49) in order to control the focusing of the laser beam (27) onto the respective contact pair (37), to which end a decoupling of the visible light from the beam path (28) of the laser beam (27) is effected.

5. A method according to claim 1 or 2, **characterised in that** a monitoring of the contact pair (37) by means of the camera device (49) and a measurement of the infrared radiation (45) emitted by the contact pair (37) is effected in order to control the effective laser capacity in the contact pair (37).

6. A device for manufacturing a thermal connection of overlapping connecting surfaces of two substrates, at least one substrate being transparent and laser energy being applied to the connecting surfaces from a rear side of the transparent substrate, comprising a laser emitting device for emitting radiation energy and a radiation transmitting device for transmitting the radiation energy from the laser emitting device to a contact pair of connecting surfaces, the radiation transmitting device comprising a first and a second swivel mirror device for generating a beam path from the laser emitting device to the contact pair which is deflected at least twice, **characterised in that** a focusing device (39), which is axially displaceable in the beam path, is arranged in the beam path (28) between the laser emitting device (11) and the contact pair (37).

7. A device according to claim 6, **characterised in that** the focusing device (39) is arranged in the beam path (28) between the first swivel mirror device (29) and the laser emitting device (11).

8. A device according to claim 7, **characterised in that** a radiation decoupling device (42) is arranged in the beam path (28) between the laser emitting device (11) and the focusing device (39) for decoupling and deflecting the visible light from the beam path into a camera device (49).

## Revendications

1. Procédé d'assemblage thermique des surfaces de raccordement de deux substrats disposées dans une couche de recouvrement, au moins un substrat étant de conformation transparente et une sollicitation à l'énergie laser des surfaces de raccordement ayant lieu à partir d'une face postérieure du substrat transparent, chacun des appariements de contact formés entre deux surfaces de raccordement des substrats opposés étant sollicité séparément à l'énergie laser,
**caractérisé en ce que**
on déplace axialement, dans un parcours optique (28) situé entre un dispositif d'émission de laser (11) et l'appariement de contact (37), un dispositif de focalisation (39) en fonction des mouvements angulaires d'un dispositif à miroir pivotant (29, 30).

2. Procédé selon la revendication 1,
**caractérisé en ce que**
le rayonnement laser (27) émis par le dispositif d'émission de laser (11) est dévié dans le parcours optique (28) par l'intermédiaire d'un premier dispositif à miroir pivotant (29) sur un deuxième dispositif à miroir pivotant (30) et du deuxième dispositif à miroir pivotant (30) sur un appariement de contact (37).

3. Procédé selon la revendication 1 ou 2,
**caractérisé en ce que**
pour contrôler la focalisation du rayonnement laser (27) sur l'appariement de contact respectif (37), une mesure du rayonnement infrarouge (45) émis par l'appariement de contact est réalisée.

4. Procédé selon la revendication 1 ou 2,
**caractérisé en ce que**
pour contrôler la focalisation du rayonnement laser (27) sur l'appariement de contact respectif (37), une surveillance optique de l'appariement de contact est effectuée au moyen d'un dispositif à caméra (49), une dissociation de la lumière visible hors du parcours optique (28) du rayonnement laser (27) étant réalisée à cet effet.

5. Procédé selon la revendication 1 ou 2,
**caractérisé en ce que**
pour contrôler la puissance effective du laser dans l'appariement de contact (37), une surveillance de l'appariement de contact (37) est réalisée au moyen du dispositif à caméra (49) ainsi qu'une mesure du rayonnement infrarouge (45) émis par cet appariement de contact.

6. Procédé de réalisation d'un assemblage thermique des surfaces de raccordement de deux substrats disposées dans une couche de recouvrement, au moins un substrat étant de conformation transparente et une sollicitation à l'énergie laser des surfaces de raccordement ayant lieu à partir d'une face postérieure du substrat transparent, présentant
un dispositif d'émission de laser pour l'émission de l'énergie de rayonnement et
un dispositif de transmission du rayonnement pour la transmission de l'énergie de rayonnement du dispositif d'émission de laser à un appariement de contact des surfaces de raccordement,
le dispositif de transmission du rayonnement présentant, pour former un parcours optique dévié au moins deux fois du dispositif d'émission de laser à l'appariement de contact, un premier et un deuxième dispositif à miroir pivotant,
**caractérisé en ce que**
dans le parcours optique (28), entre le dispositif d'émission de laser (11) et l'appariement de contact (37), est disposé un dispositif de focalisation (39) déplaçable axialement dans le parcours optique.

7. Dispositif selon la revendication 6,
**caractérisé en ce que**
le dispositif de focalisation (39) est disposé dans le parcours optique (28) entre le premier dispositif à miroir pivotant (29) et le dispositif d'émission de laser (11).

8. Dispositif selon la revendication 7,
**caractérisé en ce que**
entre le dispositif d'émission de laser (11) et le dispositif de focalisation (39), est disposé dans le parcours optique (28) un dispositif de dissociation du rayonnement (42) servant à dissocier et à dévier la lumière visible hors du parcours optique vers un dispositif à caméra (49).
